(19) **Europäisches Patentamt**
**European Patent Office**
**Office européen des brevets**

(11) **EP 1 416 287 B1**

(12) **EUROPÄISCHE PATENTSCHRIFT**

(45) Veröffentlichungstag und Bekanntmachung des Hinweises auf die Patenterteilung:
**09.03.2005 Patentblatt 2005/10**

(51) Int Cl.⁷: **G01R 31/02**

(21) Anmeldenummer: **03090224.1**

(22) Anmeldetag: **17.07.2003**

(54) **Verfahren zum Erzeugen eines einen Erdkurzschluss angebenden Fehlersignals**

Method of generating an error signal indicating a short-circuit to the earth

Procédé permettant de produire un signal d'erreur indiquant le court-circuit avec la terre

(84) Benannte Vertragsstaaten:
**AT BE BG CH CY CZ DE DK EE ES FI FR GB GR HU IE IT LI LU MC NL PT RO SE SI SK TR**

(30) Priorität: **30.10.2002 DE 10251001**

(43) Veröffentlichungstag der Anmeldung:
**06.05.2004 Patentblatt 2004/19**

(73) Patentinhaber: **SIEMENS AKTIENGESELLSCHAFT**
**80333 München (DE)**

(72) Erfinder: **Kereit, Matthias**
**12159 Berlin (DE)**

(56) Entgegenhaltungen:
**DE-A- 3 842 920          SU-A- 1 149 344**

**Beschreibung**

Zur Überwachung von mehrphasigen Energieübertragungsleitungen auf auftretende Fehler, insbesondere Kurzschlüsse, werden u. a. nach dem Distanzschutzprinzip arbeitende Schutzgeräte eingesetzt. Dabei wird die Impedanz von durch den Kurzschluss entstehenden Schleifen ermittelt und anhand dieser auf die Entfernung der Fehlerstelle von der Messstelle geschlossen. Bei der Betrachtung solcher Schleifen müssen im Wesentlichen zwei Schleifenarten unterschieden werden, die Leiter-Erde-Schleife und die Leiter-Leiter-Schleife. Bei einer Leiter-Erde-Schleife wird durch den Kurzschluss eine Verbindung mindestens eines der Phasenleiter mit Erde hergestellt, während bei einer Leiter-Leiter-Schleife zumindest zwei Leiter miteinander ohne Erdberührung kurzgeschlossen sind. Zur Ermittlung des betroffenen Leitungsabschnittes werden in beiden Fällen unterschiedliche Verfahren eingesetzt. Daher ist vor der Berechnung eine Aussage darüber zu treffen, ob es sich um einen Kurzschluss mit Erdbeteiligung (Erdkurzschluss) handelt oder nicht.

Dazu ist beispielsweise aus dem Handbuch des Siemens-Schutzgerätes 7SA522, Bestellnummer C53000-G1100-C155-2, Seiten 6-28 bis 6-30 bekannt, eine Erdfehlererkennung auf der Grundlage von Summenstrom- und Verlagerungsspannungsmessungen durchzuführen. Bei dem bekannten Verfahren wird ein einen Erdkurzschluss kennzeichnendes Fehlersignal erzeugt, wenn der Summenstrom oder die Verlagerungsspannung jeweils vorgegebene Schwellenwerte überschreiten (ODER-Verknüpfung). Dabei wird der Effekt ausgenutzt, dass sowohl ein messbarer Summenstrom als auch eine deutliche Verlagerungsspannung üblicherweise nur bei Erdkurzschlüssen auftreten, bei Kurschlüssen ohne Erdbeteiligung jedoch nicht.

Die Erfindung bezieht sich auf ein solches Verfahren und betrifft daher ein Verfahren zum Erzeugen eines einen Erdkurzschluss auf einer mehrphasigen Energieübertragungsleitung angebenden Fehlersignals, bei dem nach Auftreten eines Kurzschlusses auf der Energieübertragungsleitung die Phasenströme der Energieübertragungsleitung mittels Stromwandlern zur Bildung eines Summenstrommesswertes erfasst werden und ein erstes Erdkurzschlussverdachtssignal erzeugt wird, wenn der Summenstrommesswert einen vorgegebenen Stromschwellenwert überschreitet, die Phasenspannungen der Energieübertragungsleitung zur Bildung eines Verlagerungsspannungsmesswertes erfasst werden und ein zweites Erdkurzschlussverdachtssignal erzeugt wird, wenn der Verlagerungsspannungsmesswert einen vorgegebenen Spannungsschwellenwert überschreitet, und ein einen Erdkurzschluss angebendes Fehlersignal erzeugt wird, wenn zumindest ein Erdkurzschlussverdachtssignal vorliegt.

Geht jedoch zumindest ein bei der Summenstrombestimmung beteiligter Stromwandler in einen Sättigungszustand über, so werden die Messwerte nicht mehr korrekt erfasst, und es kann ein fehlerhafterweise von Null abweichender Summenstrom ermittelt werden. Daraufhin würde mit dem oben beschriebenen Schwellenwertverfahren auf einen Erdkurzschluss erkannt werden und die Messwerke zur Bestimmung des betroffenen Leitungsabschnitts bei einem Erdkurzschluss würden (ungewollt) freigegeben werden. Dies könnte zu einer Fehlauslösung eines an das Schutzgerät angeschlossenen Leistungsschalters führen.

Um dies zu verhindern, werden in dem bekannten Gerät eine sogenannte stabilisierte Erdstromerfassung und ein Nullstrom/Gegensystemstromvergleich durchgeführt. Da die Wahrscheinlichkeit einer auftretenden Stromwandlersättigung mit steigenden Phasenströmen zunimmt, steigt bei der stabilisierten Erdstromerfassung mit zunehmenden Phasenströmen ebenso der Schwellenwert für die Erdkurzschlusserkennung an. Um jedoch eine ausreichende Empfindlichkeit zu gewährleisten, muss die Steigung der Ansprechkennlinie relativ klein gehalten werden. Bei dem Nullstrom/Gegensystemstromvergleich wird zusätzlich zum Summenstrom der Gegenstrom auf der Energieübertragungsleitung bestimmt, und es wird aus beiden ein Wertepaar gebildet. Je nach Lage des . Wertepaares in einem Summenstrom-Gegenstrom-Diagramm wird auf einen Erdkurzschluss erkannt oder nicht.

Eine weitere bekannte Möglichkeit zur Verbesserung der Erdkurzschlusserkennung besteht darin, die Ausgänge der Schwellenwertstufen für den Summenstrom und die Verlagerungsspannung mit einem UND-Glied zu verbinden (anstelle wie oben beschrieben mit einem ODER-Glied), so dass auf einen Erdkurzschluss nur in dem Fall erkannt wird, wenn sowohl der Summenstrom als auch die Verlagerungsspannung die vorgegebenen Schwellenwerte überschreiten. Durch diese UND-Verknüpfung sinkt jedoch die Empfindlichkeit des gesamten Verfahrens, weil die Verlagerungsspannung nicht in jedem Fall, in dem ein Erdkurzschluss auftritt, über den vorgegebenen Schwellenwert ansteigt.

Der Erfindung liegt die Aufgabe zugrunde, ein Verfahren der eingangs genannten Art derart weiterzuentwickeln, dass Fehlauslösungen aufgrund von Wandlersättigung besonders wirksam vermieden werden.

Zur Lösung dieser Aufgabe ist erfindungsgemäß ausgehend von dem bekannten Verfahren vorgesehen, dass die Stromwandler auf Wandlersättigung überprüft werden und bei vorliegender Wandlersättigung zumindest eines Stromwandlers ein einen Erdkurzschluss angebendes Fehlersignal F nur dann erzeugt wird, wenn zumindest das zweite Erdkurzschlussverdachtssignal vorliegt. Die Erkennung auf Stromwandlersättigung kann dabei beispielsweise wie in der deutschen Patentschrift DE 196 33 856 C1 beschrieben erfolgen. Der wesentliche Vorteil des erfindungsgemäßen Verfahrens besteht darin, dass eine Fehlauslösung von Leistungsschaltern aufgrund eines durch Wandlersättigung verfälschten Summenstrommesswertes wirksam vermieden wird. Es wird nämlich ein einen Erdkurzschluss kennzeichnendes Fehlersignal nur dann erzeugt, wenn die Verlagerungsspannung den vorgegebenen Spannungsschwellenwert übersteigt.

Eine vorteilhafte Weiterbildung des erfindungsgemäßen Verfahrens sieht vor, dass der Stromschwellenwert in Abhängigkeit vom maximalen Phasenstrom der Energieübertragungsleitung eingestellt wird. Auf diese Weise kann gerade für den Fall, dass keine Wandlersättigung vorliegt, der Schwellenwert automatisch an den Phasenstrom angepasst werden.

Eine weitere vorteilhafte Ausführungsform der Erfindung sieht vor, dass aus den Phasenströmen auch ein Gegensystemstrommesswert gebildet wird und ein weiteres Erdkurzschlussverdachtssignal erzeugt wird, wenn ein aus dem Summenstrommesswert und dem Gegensystemstrommesswert gebildetes Wertepaar innerhalb eines vorgegebenen Auslösebereiches liegt. Auf diese Weise kann die Empfindlichkeit des erfindungsgemäßen Verfahrens insbesondere für den Fall ohne Wandlersättigung weiter erhöht werden.

Die Erfindung betrifft auch eine Anordnung zum Erzeugen eines einen Erdkurzschluss auf einer mehrphasigen Energieübertragungsleitung angebenden Fehlersignals, die zumindest ein Stromwandler zum Erfassen des Summenstromes der Phasenleiter der Energieübertragungsleitung, eine mit dem zumindest einen Stromwandler eingangsseitig verbundene Stromschwellenwertstufe, zumindest ein Spannungswandler zum Erfassen der Verlagerungsspannung der Phasenleiter der Energieübertragungsleitung, eine mit dem zumindest einen Spannungswandler eingangsseitig verbundene Spannungsschwellenwertstufe und eine Auswerteeinrichtung aufweist, die ein einen Erdkurzschluss angebendes Fehlersignal erzeugt, wenn der Summenstrom den Stromschwellenwert oder die Verlagerungsspannung den Spannungsschwellenwert überschreitet.

Eine solche Anordnung ist ebenfalls aus dem eingangs genannten Handbuch des Siemens-Schutzgeräts 7SA522 bekannt.

Um bei einer solchen Anordnung noch zuverlässiger Fehlauslösungen aufgrund von Stromwandlersättigung zu vermeiden, ist bei einer Anordnung der genannten Art erfindungsgemäß vorgesehen, dass mit den Stromwandlern auch eine Sättigungserkennungseinrichtung verbunden ist, die ein Sättigungssignal abgibt, wenn eine Stromwandlersättigung vorliegt, und mit einem Ausgang der Sättigungserkennungseinrichtung die Auswerteeinrichtung verbunden ist, die bei anstehendem Sättigungssignal das einen Erdkurzschluss angebende Fehlersignal nur dann ausgangsseitig abgibt, wenn die Verlagerungsspannung den Spannungsschwellenwert überschreitet.

Eine Entscheidung aufgrund einer durch Wandlersättigung gestörten Stromerfassung wird somit vorteilhaft ausgeschlossen. Die Sättigungserkennungseinrichtung, die beispielsweise wie in dem deutschen Patent DE 196 33 856 C1 beschrieben ausgeführt sein kann, erzeugt hierbei ein Signal, bei dessen Auftreten nur dann auf einen Erdkurzschluss erkannt werden kann, wenn die Verlagerungsspannung den vorgegebenen Schwellenwert überschreitet.

Zur weiteren Erläuterung der Erfindung ist in

Figur 1　eine schematische Blockdarstellung einer Anordnung zur Durchführung des erfindungsgemäßen Verfahrens, in

Figur 2　eine schematische Blockdarstellung einer Anordnung zur Durchführung einer vorteilhaften Weiterbildung des erfindungsgemäßen Verfahrens, in

Figur 3　ein Diagramm zur Erläuterung der Einstellung des Stromschwellenwertes und in

Figur 4　ein Diagramm zur Erläuterung des Summenstroms/Gegensystemstromvergleichs gezeigt.

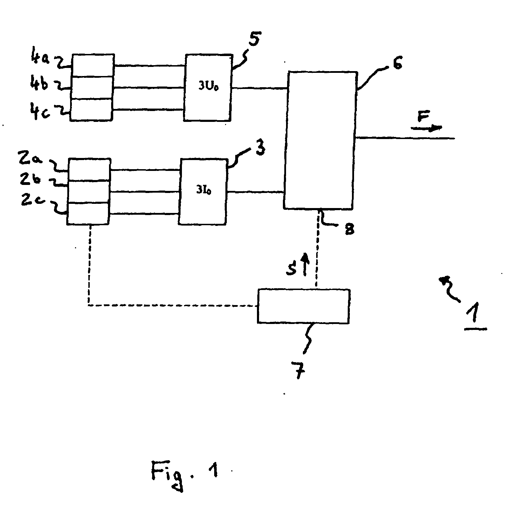

In Figur 1 ist eine Anordnung 1 zum Erzeugen eines einen Erdkurzschluss angebenden Fehlersignals F dargestellt. Mit einer in der Figur nicht dargestellten Energieübertragungsleitung sind über Stromwandler 2a, 2b, 2c eine Summenstromerfassungseinrichtung 3 und über Spannungswandler 4a, 4b, 4c eine Verlagerungsspannungserfassungseinrichtung 5 verbunden. Die Anzahl der Stromwandler 2a, 2b, 2c und der Spannungswandler 4a, 4b, 4c entspricht dabei der Anzahl der Phasenleiter der Energieübertragungsleitung. Anstelle der mehreren Strom- bzw. Spannungswandler kann im Rahmen der Erfindung auch je ein Wandler zur direkten Erfassung von Summenstrom bzw. Verlagerungsspannung vorgesehen sein, beispielsweise ein Umbauwandler zur Summenstromerfassung. Im Folgenden soll jedoch eine Anordnung mit mehreren Strom- Bzw. Spannungswandlern gemäß Fig. 1 betrachtet werden.

Die mit den Strom- bzw. Spannungswandlern jeweils erfassten Strom- bzw. Spannungszeiger werden in der Summenstromerfassungseinrichtung 3 bzw. der Verlagerungsspannungserfassungseinrichtung 5 bei einer dreiphasigen Energieübertragungsleitung gemäß den folgenden Gleichungen 1 und 2 unter Bildung des Summenstromes $3I_0$ (Gleichung 1) bzw. der Verlagerungsspannung $3U_0$ (Gleichung 2) addiert:

$$3\underline{I}_0 = \underline{I}_{L1} + \underline{I}_{L2} + \underline{I}_{L3} \qquad (1)$$

$$3\underline{U}_0 = \underline{U}_{L1} + \underline{U}_{L2} + \underline{U}_{L3} \qquad (2)$$

Dabei stehen die Indizes $L_1$, $L_2$ und $L_3$ für den jeweiligen Phasenleiter. Summenstrom $3I_0$ und Verlagerungspannung $3U_0$ werden anschließend verschiedenen Eingängen einer Auswerteeinrichtung 6 zugeführt. Mit den Stromwandlern 2a, 2b, 2c der Stromerfassungseinrichtung 3 ist zusätzlich eine Sättigungserkennungseinrichtung 7 verbunden. In Figur 1 ist diese Verbindung durch eine strichlierte Linie dargestellt; real ist jeder Stromwandler mit einer eigenen Sättigungserkennungseinrichtung bzw. einer allen Stromwandlern gemeinsamen Sättigungserkennungseinrichtung jeweils über eine separate elektrische Verbindung verbunden. Die Sättigungserkennungseinrichtung 7 ist ausgangsseitig wiederum mit einem Steuereingang 8 der Auswerteeinrichtung 6 verknüpft.

Zur Erkennung eines Erdkurzschlusses bei der in der Figur 1 nicht gezeigten Energieübertragungsleitung werden mittels der Summenstromerfassungseinrichtung 3 und der Verlagerungsspannungserfassungseinrichtung 5 aus den einzelnen Phasenströmen bzw. -spannungen gemäß den angegebenen Gleichungen 1 und 2 der Summenstrom $3I_0$ bzw. die Verlagerungsspannung $3U_0$ gebildet. Im Normalbetrieb ohne Wandlersättigung nehmen diese beiden Größen üblicherweise Werte nahe Null an. Tritt nun ein Kurzschluss auf der Energieübertragungsleitung auf, wird der Algorithmus zur Erdkurzschlusserkennung gestartet. Dazu werden in der Auswerteeinrichtung 6 der ermittelte Summenstrom $3I_0$ mit einem Stromschwellenwert und die ermittelte Verlagerungsspannung $3U_0$ mit einem entsprechenden Spannungsschwellenwert verglichen. Übersteigt der Summenstrom den Stromschwellenwert, so wird ein internes Erdkurzschlussverdachtssignal erzeugt; analog wird ein zweites Erdkurzschlussverdachtsignal erzeugt, wenn die Verlagerungsspannung den Spannungsschwellenwert überschreitet. Liegt wenigstens eines der beiden Erdkurzschlussverdachtssignale vor, so wird (in dem Fall, dass keine Wandlersättigung vorliegt) auf einen Erdkurzschluss erkannt und am Ausgang der Auswerteeinrichtung 6 ein entsprechendes Fehlersignal F erzeugt.

Erkennt die Sättigungserkennungseinrichtung 7 nach Auftreten des Kurzschlusses auf der Energieübertragungsleitung jedoch, dass zumindest einer der Stromwandler 2a, 2b, 2c sich in einem Sättigungszustand befindet, so wird an ihrem Ausgang ein Sättigungssignal S erzeugt und dem Steuereingang 8 der Auswerteeinrichtung 6 zugeführt. Die Auswerteeinrichtung 6 ihrerseits ist derart eingestellt, dass bei einem anstehenden Sättigungssignal S am Steuereingang 8 das einen Erdkurzschluss angebende Fehlersignal F nur dann erzeugt wird, wenn die Verlagerungsspannung $3U_0$ den Spannungsschwellenwert überschreitet. Der aufgrund der Wandlersättigung unzuverlässige Summenstromwert $3I_0$ geht in diesem Fall also nicht mehr als Entscheidungskriterium in die Erdkurzschlusserkennung ein. Das einen Erdkurzschluss angebende Fehlersignal F wird also in dem Fall vorliegender Wandlersättigung nur dann erzeugt, wenn gemäß dem Kriterium der Verlagerungsspannung ein Erdkurzschluss auf der Energieübertragungsleitung vorliegt.

Das einen Erdkurzschluss angebende Fehlersignal F dient üblicherweise einem Schutzgerät (in Figur 1 nicht dargestellt) zur Aktivierung entsprechender Messwerke für die Bestimmung des betroffenen Leitungsabschnitts. Ein fälschlicherweise erzeugtes Fehlersignal F kann somit zur ungewollten Aktivierung der Messwerke und gegebenenfalls zur ungewollten Auslösung eines mit dem Schutzgerät verbundenen Leistungsschalters führen. Bei einer ungewollten Auslösung eines Leistungsschalters wird der entsprechende Abschnitt der Energieübertragungsleitung vom Netz getrennt, obwohl dort kein Erdkurzschluss vorliegt. Eine solche Fehlauslösung kann mit dem erfindungsgemäßen Verfahren verhindert werden.

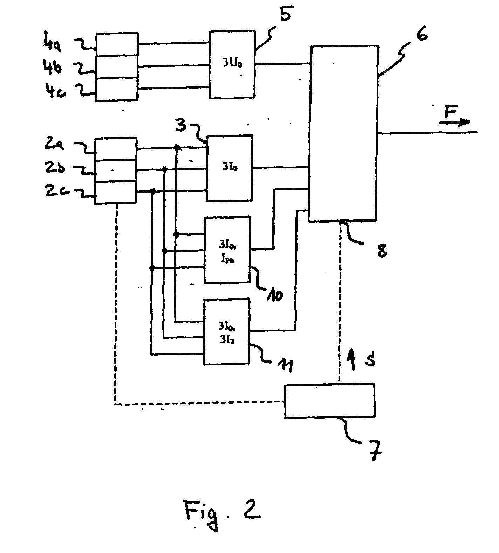

In Figur 2 ist eine vorteilhafte Weiterbildung der Anordnung zum Erzeugen eines einen Erdkurzschluss angebenden Fehlersignals gezeigt. Der Figur 1 entsprechende Komponenten sind mit den selben Bezugszeichen gekennzeichnet. Zusätzlich zur der Anordnung gemäß Figur 1 sind in Figur 2 ein Baustein zur stabilisierten Summenstromerfassung 10 und ein Baustein zum Summenstrom/Gegensystemstrom-Vergleich 11 dargestellt, die eingangsseitig mit den Stromwandlern 2a, 2b, 2c und ausgangsseitig mit der Auswerteeinrichtung 6 verbunden sind.

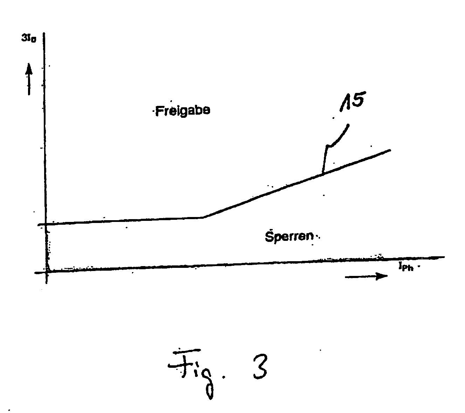

Mit Hilfe des Bausteins zur stabilisierten Summenstromerfassung 10 kann der Stromschwellenwert, mit dem der Summenstrom $3I_0$ verglichen wird, dynamisch an die Größe des maximalen Phasenleiterstromes $I_{Ph}$ angepasst werden. Dies ist in Figur 3 näher erläutert. Figur 3 zeigt ein Diagramm, in dem der Summenstrom $3I_0$ über dem maximalen Phasenleiterstrom $I_{Ph}$ aufgetragen ist. Die durchgezogene Linie bezeichnet die Kennlinie 15, nach der der jeweilige Schwellenwert für den Summenstrom $3I_0$ eingestellt wird. Man erkennt, dass bei hohen Phasenströmen $I_{Ph}$ der Schwellenwert jeweils ansteigt, während der Schwellenwert bei niedrigen Phasenströmen $I_{Ph}$ konstant ist. Liegt nun ein entsprechendes Wertepaar $(3I_0, I_{Ph})$ in dem mit "Freigabe" gekennzeichneten Bereich oberhalb der Kennlinie 15, so wird nach dem Summenstromkriterium auf einen Erdkurzschluss erkannt. Liegt ein entsprechendes Wertepaar $(3I_0, I_{Ph})$ unterhalb der Kennlinie (also in dem mit "Sperren" gekennzeichneten Bereich) so wird nach dem Summenstromkriterium auf einen Kurzschluss ohne Erdbeteiligung erkannt.

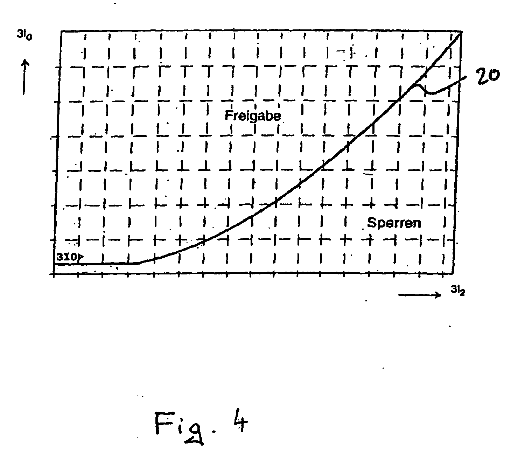

Mit dem Baustein zum Summenstrom/Gegensystemstrom-Vergleich wird die Empfindlichkeit und Zuverlässigkeit der Anordnung noch weiter erhöht. Die Funktionsweise ist in dem gemäß Figur 4 -dargestellten Diagramm erläutert. Darin ist der Summenstrom $3I_0$ über den Gegensystemstrom $3I_2$ aufgetragen. Die Bestimmung des Gegensystemstroms $3I_2$ erfolgt dabei nach Gleichung 3:

$$3\underline{I}_2 = \underline{I}_{L1} + a^2 \, \underline{I}_{L2} + a \, \underline{I}_{L3}, \tag{3}$$

mit $a = e^{j\,(2\pi/3)}$. In dem Diagramm gemäß Figur 4 ist ein typischer Wertebereich für die Erzeugung eines weiteren Erdkurzschlussverdachtssignals festgelegt., Fällt ein Wertepaar ($3I_0$, $3I_2$) in diesen in der Figur 4 mit "Freigabe" bezeichneten Bereich, so wird das weitere Erdkurzschlussverdachtssignal erzeugt, liegt es in dem mit "Sperren" gekennzeichneten Bereich, so wird kein Erdkurzschlussverdachtssignal erzeugt. Die beiden Bereiche (Freigabe", "Sperren")sind durch die Kennlinie 20 voneinander getrennt.

Die Funktionsweise bei Stromwandlersättigung entspricht dem in Figur 1 beschriebenen Verfahren. Wird in der Sättigungserkennungseinrichtung 5 eine Stromwandlersättigung erkannt, so wird folglich ein einen Erdkurzschluss angebendes Fehlersignal F nur dann erzeugt, wenn die Verlagerungsspannung $3\underline{U}_0$ oberhalb des Spannungsschwellenwertes liegt. Das Summenstromkriterium wird in diesem Fall nicht für die Entscheidung, ob ein Erdkurzschluss vorliegt, verwendet.

**Patentansprüche**

1. Verfahren zum Erzeugen eines einen Erdkurzschluss auf einer mehrphasigen Energieübertragungsleitung angebenden Fehlersignals, bei dem nach Auftreten eines Kurzschlusses auf der Energieübertragungsleitung

   - die Phasenströme der Energieübertragungsleitung mittels Stromwandlern zur Bildung eines Summenstrommesswertes erfasst werden und ein erstes Erdkurzschlussverdachtssignal erzeugt wird, wenn der Summenstrommesswert einen vorgegebenen Stromschwellenwert überschreitet,
   - die Phasenspannungen der Energieübertragungsleitung zur Bildung eines Verlagerungsspannungsmesswertes erfasst werden und ein zweites Erdkurzschlussverdachtssignal erzeugt wird, wenn der Verlagerungsspannungsmesswert einen vorgegebenen Spannungsschwellenwert überschreitet, und
   - ein einen Erdkurzschluss angebendes Fehlersignal erzeugt wird, wenn zumindest ein Erdkurzschlussverdachtssignal vorliegt,

   **dadurch gekennzeichnet, dass**

   - die Stromwandler auf Wandlersättigung überprüft werden und
   - bei vorliegender Wandlersättigung zumindest eines Stromwandlers ein einen Erdkurzschluss angebendes Fehlersignal F dann erzeugt wird, wenn zumindest das zweite Erdkurzschlussverdachtssignal vorliegt.

2. Verfahren nach Anspruch 1,
   **dadurch gekennzeichnet,**
   **dass** der Stromschwellenwert in Abhängigkeit vom maximalen Phasenstrom der Energieübertragungsleitung eingestellt wird.

3. Verfahren nach Anspruch 1 oder 2,
   **dadurch gekennzeichnet, dass**

   - aus den Phasenströmen auch ein Gegensystemstrommesswert gebildet wird und
   - ein weiteres Erdkurzschlussverdachtssignal erzeugt wird, wenn ein aus dem Summenstrommesswert und dem Gegensystemstrommesswert gebildetes Wertepaar innerhalb eines vorgegebenen Auslösebereiches liegt.

4. Anordnung zum Erzeugen eines einen Erdkurzschluss auf einer mehrphasigen Energieübertragungsleitung angebenden Fehlersignals, die

   - zumindest einen Stromwandler zum Erfassen des Summenstromes der Phasenleiter der Energieübertragungsleitung,
   - eine mit dem zumindest einen Stromwandler eingangsseitig verbundene Stromschwellenwertstufe,
   - zumindest einen Spannungswandler zum Erfassen der Verlagerungsspannung der Phasenleiter der Energieübertragungsleitung,
   - eine mit dem zumindest einen Spannungswandler eingangsseitig verbundene Spannungsschwellenwertstufe und
   - eine Auswerteeinrichtung aufweist, die ein einen Erdkurzschluss angebendes Fehlersignal erzeugt, wenn der Summenstrom den Stromschwellenwert oder die Verlagerungsspannung den Spannungsschwellenwert überschreitet,

   **dadurch gekennzeichnet, dass**

   - mit dem zumindest einen Stromwandler auch eine Sättigungserkennungseinrichtung verbunden ist, die ein Sättigungssignal abgibt, wenn eine Stromwandlersättigung vorliegt, und
   - mit einem Ausgang der Sättigungserkennungseinrichtung die Auswerteeinrichtung verbunden ist, die bei anstehendem Sättigungssignal das einen Erdkurzschluss angebende Fehlersignal dann ausgangsseitig abgibt, wenn die Verlagerungsspannung den Spannungsschwellenwert überschreitet.

**Claims**

1. Method for producing a fault signal which indicates a short to earth on a polyphase power transmission line, in which, after a short occurs on the power transmission line,

- the phase currents on the power transmission line are detected by means of current transformers in order to form a sum current measured value, and a first short to earth suspicion signal is produced if the sum current measured value is greater than a predetermined current threshold value,
- the phase voltages on the power transmission line are detected in order to form a residual voltage measured value, and a second short to earth suspicion signal is produced if the residual voltage measured value is greater than a predetermined voltage threshold value, and
- a fault signal which indicates a short to earth is produced if at least one short to earth suspicion signal is present,

**characterized in that**,

- the current transformers are checked for transformer saturation, and
- if transformer saturation is present in at least one current transformer, a fault signal F which indicates a short to earth is produced when at least the second short to earth suspicion signal is present.

2. Method according to Claim 1,
   **characterized**
   **in that** the current threshold value is set as a function of the maximum phase current in the power transmission line.

3. Method according to Claim 1 or 2,
   **characterized in that**

- a negative phase sequence system current measured value is formed from the phase currents, and
- a further short to earth suspicion signal is produced when a value pair which is formed from the sum current measured value and the negative phase sequence system current measured value is within a predetermined tripping range.

4. Arrangement for producing a fault signal which indicates a short to earth on a polyphase power transmission line, which arrangement has

- at least one current transformer for detecting the sum current in the phase conductors of the power transmission line,
- a current threshold value stage which is connected on the input side to the at least one current transformer,

- at least one current transformer for detecting the residual voltage of the phase conductors of the power transmission line,
- a voltage threshold value stage which is connected on the input side to the at least one voltage transformer, and
- an evaluation device which produces a fault signal which indicates a short to earth, when the sum current is greater than the current threshold value or the residual voltage is greater than the voltage threshold value,

**characterized in that**

- a saturation identification device is also connected to the at least one current transformer and emits a saturation signal when current transformer saturation is present, and
- the evaluation device is connected to one output of the saturation identification device and, when a saturation signal is present, emits the fault signal (which indicates a short to earth) on the output side when the residual voltage is greater than the voltage threshold value.

**Revendications**

1. Procédé pour produire un signal d'erreur indiquant un court-circuit à la terre sur une ligne de transmission d'énergie polyphasée, dans lequel, après l'apparition d'un court-circuit sur la ligne de transmission d'énergie,

- on détecte les courants de phases de la ligne de transmission d'énergie au moyen de convertisseurs de courant pour former une valeur mesurée de courant cumulé et on produit un premier signal de soupçon de court-circuit à la terre si la valeur mesurée de courant cumulé dépasse une valeur de seuil de courant prédéterminée,
- on détecte les tensions de phases de la ligne de transmission d'énergie pour former une valeur mesurée de tension décalée et on produit un deuxième signal de soupçon de court-circuit à la terre si la valeur mesurée de tension décalée dépasse une valeur de seuil de tension prédéterminée, et
- on produit un signal d'erreur indiquant un court-circuit à la terre s'il existe au moins un signal de soupçon de court-circuit à la terre,

   **caractérisé par le fait que**

- on teste les convertisseurs de courant pour détecter une éventuelle saturation de convertisseur, et

- en présence d'une saturation au moins d'un convertisseur de courant, on produit un signal d'erreur F indiquant un court-circuit à la terre s'il existe au moins le deuxième signal de soupçon de court-circuit à la terre.

2. Procédé selon la revendication 1, **caractérisé par le fait qu'**on règle la valeur de seuil de courant en fonction du courant de phase maximal de la ligne de transmission d'énergie.

3. Procédé selon la revendication 1 ou 2, **caractérisé par le fait que**

   - on forme aussi une valeur mesurée de courant de système inverse à partir des courants de phases, et
   - on produit un autre signal de soupçon de court-circuit à la terre si un couple de valeurs formé par la valeur mesurée de courant cumulé et par la valeur mesurée de courant de système inverse se trouve à l'intérieur d'une plage de déclenchement prédéterminée.

4. Dispositif pour produire un signal d'erreur indiquant un court-circuit à la terre sur une ligne de transmission d'énergie polyphasée, qui comporte

   - au moins un convertisseur de courant pour détecter le courant cumulé des conducteurs de phases de la ligne de transmission d'énergie,
   - un étage à valeur de seuil de courant relié côté entrée au seul ou aux plusieurs convertisseurs de courant,
   - au moins un convertisseur de tension pour détecter la tension décalée des conducteurs de phases de la ligne de transmission d'énergie,
   - un étage à valeur de seuil de tension relié côté entrée au seul ou aux plusieurs convertisseurs de tension, et
   - un dispositif d'évaluation qui produit un signal d'erreur indiquant un court-circuit à la terre si le courant cumulé dépasse la valeur de seuil de courant ou si la tension décalée dépasse la valeur de seuil de tension,

   **caractérisé par le fait que**

   - il est aussi relié au seul ou aux plusieurs convertisseurs de courant un dispositif détecteur de saturation qui délivre un signal de saturation s'il existe une saturation de convertisseur de courant, et
   - il est relié à une sortie du dispositif détecteur de saturation le dispositif d'évaluation qui, en présence d'un signal de saturation, délivre en sortie un signal d'erreur indiquant un court-circuit à la terre si la tension décalée dépasse la valeur de seuil de tension.

Fig. 1

Fig. 2

Fig. 3

Fig. 4